# EUROPEAN PATENT APPLICATION

(11) **EP 4 108 701 A1**
(43) Date of publication of application: **28.12.2022**
(21) Application number: 21757001.9
(22) Date of filing: 17.02.2021
(51) Int. Cl.: C08G 61/12, H01L 51/50

(54) **HIGH MOLECULAR WEIGHT COMPOUND AND LIGHT EMITTING DIODE INCLUDING SAID HIGH MOLECULAR WEIGHT COMPOUND**

(30) Priority: 20.02.2020 JP 2020027535
(71) Applicant: Hodogaya Chemical Co., Ltd., Tokyo, 105-0021 (JP)
(72) Inventor: TOGASHI, Kazunori, Tokyo 104-0028 (JP); KITAHARA, Hideyoshi, Tokyo 104-0028 (JP); MOCHIZUKI, Shunji, Tokyo 104-0028 (JP); HIRAI, Hiroki, Tokyo 104-0028 (JP); SHINODA, Mika, Tokyo 104-0028 (JP); SAEGUSA, Yuta, Tokyo 104-0028 (JP)
(74) Representative: Forstmeyer, Dietmar
(86) International application number: PCT/JP2021/005796
(87) International publication number: WO 2021/166921

(57) **Abstract**

It is an object of the present invention to provide a high molecular weight compound that has excellent hole-injecting/transporting performance, is capable of blocking electrons, and is highly stable in a thin film state. It is another object of the invention to provide a light emitting diode with high luminous efficacy and a long lifespan, containing an organic layer (thin film) made of the above-described high molecular weight compound. The high molecular weight compound according to the present invention includes a repeating unit constituted by a specific triarylamine structural unit and a specific bonding structural unit, and has a weight average molecular weight in terms of polystyrene of 10,000 or more and less than 1,000,000.

## Description

### Technical Field

The present invention relates to a high molecular weight compound suitable for an organic electroluminescence device (organic EL device), which is a type of light emitting diode and is a self-emissive device favorably used in various types of display apparatuses, and also relates to an organic EL device.

### Background Art

Since organic EL devices are self-emissive devices, they have larger brightness and better viewability than liquid crystal devices, and can thus provide a clearer display. For these reasons, active studies have been carried out on organic EL devices.

Organic EL devices have a configuration in which a thin film (organic layer) made of an organic compound is sandwiched between an anode and a cathode. The methods for forming the thin film can be roughly classified into a vacuum deposition method and a coating method. The vacuum deposition method is a method in which a low molecular compound is mainly used to form a thin film on a substrate by vapor deposition in vacuum, and is a technique that is already in practical use. The coating method is a method in which a high molecular compound is mainly used to form a thin film on a substrate by inkjet printing or other printing involving use of a solution, and is a technique that is essential for future large area organic EL displays because it achieves high efficiency in material usage and is suitable for displays having a larger area and higher resolution.

The vacuum deposition method involving using a low molecular material has very low efficiency in material usage, and if the vacuum deposition method is used for a large substrate, there may be significant warping of a shadow mask. Thus, it is difficult to deposit a uniform thin film on a large substrate by the vacuum deposition method. The method also has the problem of high production costs.

On the other hand, a polymer material can form a uniform film even on a large substrate by applying a solution prepared by dissolving the polymer material in an organic solvent. Thus, a thin film can be formed from a polymer material using a coating method typified by an inkjet method or a printing method. Accordingly, the efficiency in material usage can be increased, and thus the production costs of organic EL devices can be reduced significantly.

Various studies have been conducted on organic EL devices in which a polymer material is used. However, a problem therewith is that the device characteristics such as luminous efficacy and lifespan are not necessarily sufficient (see Patent Literatures 1 to 5, for example).

The most important matter for improving the performance of high molecular organic EL devices is a technique for forming an upper layer by coating without disturbing the underlying thin film. A solution prepared by dissolving a material in an organic solvent is applied when fabricating a high molecular organic EL device, and thus, a thin film as a lower layer may elute into the solvent in which the materials of the upper layer are dissolved. Accordingly, this method is disadvantageous in that it is difficult to arranging layers one on top of another, compared to the vacuum deposition method.

There are roughly two types of approaches to arranging layers one on top of another for high molecular organic EL devices. In one approach, a crosslinker is added to the material for forming an underlying layer. After the material for forming an underlying layer is applied, cross-linking is promoted through heat treatment so that the material is made insoluble in the organic solvent. In the other technique, the type of solvent to be used to dissolve the material for forming an upper layer is appropriately selected. When an organic solvent in which the material for forming underlying layer is insoluble is selected, elution of the underlying layer during application of the upper layer can be prevented.

So-called TFB, which is a fluorene polymer with no crosslinker, is known as a typical hole-transporting material that has been used in organic EL polymer devices (see Patent Literatures 6 and 7). However, TFB is insufficient in terms of hole-transporting performance and electron-blocking performance. Accordingly, a problem with TFB is that some electrons pass through a light-emitting layer, and that thus an improvement in luminous efficacy cannot be expected. Another problem with TFB is that TFB has less film adhesion to adjacent layers, and that thus an increase in the lifespan of devices cannot be expected.

### Citation List

### Patent Literatures

Patent Literature 1: JP 2005-272834A
Patent Literature 2: JP 2007-119763A
Patent Literature 3: JP 2007-162009A
Patent Literature 4: JP 2007-177225A
Patent Literature 5: WO 2005/049546
Patent Literature 6: WO 99/54385
Patent Literature 7: WO 2005/059951

### Summary of Invention

It is an object of the present invention to provide a polymer material that has excellent hole-injecting/transporting performance, is capable of blocking electrons, and is highly stable in a thin film state. It is another object of the present invention to provide a light emitting diode (in particular, a high molecular organic EL device) having a low driving voltage, high luminous efficacy, and a long lifespan, and containing an organic layer (thin film) made of the above-described polymer material.

The inventors of the present invention have focused on the fact that a triarylamine with a fluorene structure has high hole-injecting/transporting capability and is expected to realize a wide bandgap, and have conducted studies by synthesizing various high molecular weight compounds having triarylamine structural units with a fluorene structure. As a result, they have found a high molecular weight compound that has a novel structure and also has, in addition to the hole-injecting/transporting capability, a wide bandgap, excellent heat resistance, and stability in the form of a thin film. The present invention has thus been accomplished.

The present invention provides a high molecular weight compound including a repeating unit represented by a general formula (3) below constituted by a triarylamine structural unit represented by a general formula (1) below and a bonding structural unit represented by a general formula (2) below.

The present invention provides a light emitting diode including a pair of electrodes and one or more organic layers sandwiched therebetween, in which at least one of the organic layers contains the high molecular weight compound, as a constituent material.

In the light emitting diode of the present invention, the organic layer is preferably a hole-transporting layer, an electron-blocking layer, a hole-injecting layer, or a light-emitting layer.

Specifically, the present invention is as follows.
[1] A high molecular weight compound including a repeating unit represented by a general formula (3) below, which is constituted by a triarylamine structural unit represented by a general formula (1) below and a bonding structural unit represented by a general formula (2) below, and having a weight average molecular weight of 10,000 or more and less than 1,000,000, in terms of polystyrene: 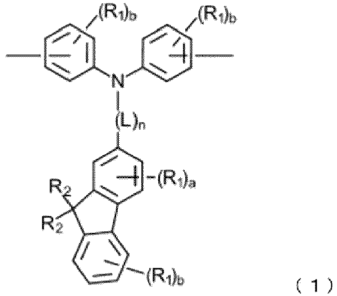 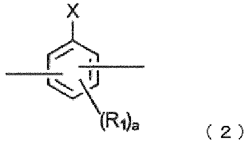 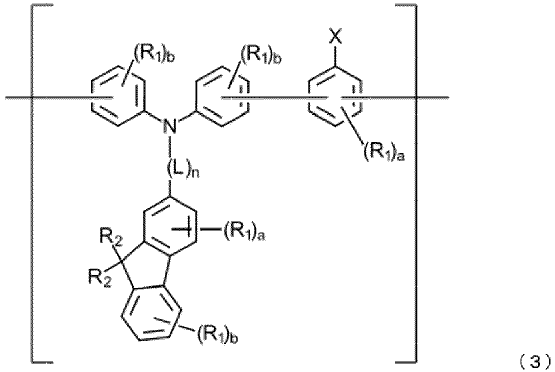
   where R₁ each independently represents a deuterium atom, a cyano group, a nitro group, a fluorine atom, a chlorine atom, a bromine atom, an iodine atom, an alkyl group or alkyloxy group having 1 to 8 carbon atoms, a cycloalkyl group or cycloalkyloxy group having 5 to 10 carbon atoms, an alkenyl group having 2 to 6 carbon atoms, or an aryloxy group,
   R₂ each independently represents an alkyl group or alkyloxy group having 1 to 8 carbon atoms, or a cycloalkyl group or cycloalkyloxy group having 5 to 10 carbon atoms,
   X represents a hydrogen atom, an amino group, a monovalent aryl group, or a monovalent heteroaryl group,
   L represents a divalent phenyl group,
   n represents an integer of 0 to 3,
   a represents an integer of 0 to 3, and
   b represents an integer of 0 to 4.
[2] The high molecular weight compound as set forth in [1], in which a and b are 0.
[3] The high molecular weight compound as set forth in [1] or [2], in which R₂ is an alkyl group having 1 to 8 carbon atoms.
[4] The high molecular weight compound as set forth in any one of [1] to [3], in which X is a hydrogen atom.
[5] The high molecular weight compound as set forth in any one of [1] to [3], in which X is a diphenylamino group, a phenyl group, a naphthyl group, a dibenzofuranyl group, a dibenzothienyl group, a phenanthrenyl group, a fluorenyl group, a carbazolyl group, an indenocarbazolyl group, or an acridinyl group.
[6] A light emitting diode including a pair of electrodes and one or more organic layers sandwiched therebetween,
   in which at least one of the organic layers contains the high molecular weight compound as set forth in any one of [1] to [5], as a constituent material.
[7] The light emitting diode as set forth in [6], in which the organic layer is a hole-transporting layer.
[8] The light emitting diode as set forth in [6], in which the organic layer is an electron-blocking layer.
[9] The light emitting diode as set forth in [6], in which the organic layer is a hole-injecting layer.
[10] The light emitting diode as set forth in [6], in which the organic layer is a light-emitting layer.
[11] The light emitting diode as set forth in any one of [6] to [10], which is an organic electroluminescence device.

The high molecular weight compound according to the present invention includes the triarylamine structural unit (divalent group) represented by the general formula (1) above and the bonding structural unit (divalent group) represented by the general formula (2). The high molecular weight compound according to the present invention is, for example, a polymer that includes the structural units as a repeating unit, and preferably has a weight average molecular weight of 10,000 or more and less than 1,000,000, in terms of polystyrene, as measured using GPC (gel permeation chromatography).

The high molecular weight compound according to the present invention has the following characteristics:
(1) good hole-injecting performance;
(2) high hole mobility;
(3) wide bandgap, and excellent electron-blocking capability;
(4) good stability in the form of a thin film; and
(5) excellent heat resistance.

An organic EL device in which an organic layer (for example, a hole-transporting layer, an electron-blocking layer, a hole-injecting layer, or a light-emitting layer) made of the high molecular weight compound of the present invention is formed between a pair of electrodes has the following advantages:
(1) high luminous efficacy and high power efficiency;
(2) a low actual driving voltage; and
(3) a long lifespan.

### Brief Description of Drawings

[Fig. 1] Fig. 1 shows the chemical structures of structural units 1 to 11, which are preferable as a bonding structural unit represented by the general formula (2) according to the present invention.
[Fig. 2] Fig. 2 shows the chemical structures of structural units 12 to 21, which are preferable as a bonding structural unit represented by the general formula (2) according to the present invention.
[Fig. 3] Fig. 3 shows the chemical structures of structural units 22 to 31, which are preferable as a bonding structural unit represented by the general formula (2) according to the present invention.
[Fig. 4] Fig. 4 shows the chemical structures of structural units 32 to 38, which are preferable as a bonding structural unit represented by the general formula (2) according to the present invention.
[Fig. 5] Fig. 5 is a diagram showing an example of a layer configuration of an organic EL device of the present invention.
[Fig. 6] Fig. 6 is a ¹H-NMR chart of Compound A, which was synthesized in Example 1 as a high molecular weight compound according to the present invention.
[Fig. 7] Fig. 7 is a ¹H-NMR chart of Compound B, which was synthesized in Example 2 as a high molecular weight compound according to the present invention.
[Fig. 8] Fig. 8 is a ¹H-NMR chart of Compound C, which was synthesized in Example 3 as a high molecular weight compound according to the present invention.

### Description of Embodiments

### <Triarylamine Structural Unit and Bonding Structural Unit>

Both of a triarylamine structural unit and a bonding structural unit included in the high molecular weight compound according to the present invention are divalent groups, and respectively represented by general formulas (1) and (2) below.

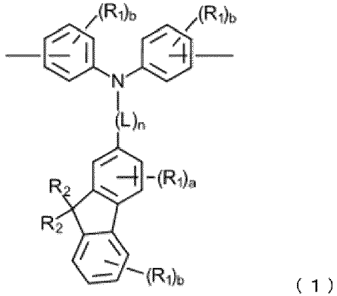

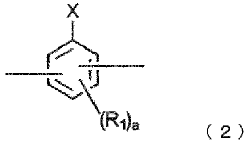

In the general formulas (1) and (2) above, R₁ each independently represents a hydrogen atom, a deuterium atom, a cyano group, a nitro group, a fluorine atom, a chlorine atom, a bromine atom, an iodine atom, an alkyl group or alkyloxy group having 1 to 8 carbon atoms, a cycloalkyl group or cycloalkyloxy group having 5 to 10 carbon atoms, an alkenyl group having 2 to 6 carbon atoms, or an aryloxy group.

For Ri, examples of the alkyl group, the alkyloxy group, the cycloalkyl group, the cycloalkyloxy group, the alkenyl group, and the aryloxy group mentioned above include the following groups.

Examples of the alkyl group (having 1 to 8 carbon atoms) include a methyl group, an ethyl group, an n-propyl group, an isopropyl group, an n-butyl group, an isobutyl group, a tert-butyl group, an n-pentyl group, an isopentyl group, a neopentyl group, an n-hexyl group, an isohexyl group, a neohexyl group, an n-heptyl group, an isoheptyl group, a neoheptyl group, an n-octyl group, an isooctyl group, and a neooctyl group.

Examples of the alkyloxy group (having 1 to 8 carbon atoms) include a methyloxy group, an ethyloxy group, an n-propyloxy group, an isopropyloxy group, an n-butyloxy group, a tert-butyloxy group, an n-pentyloxy group, an n-hexyloxy group, an n-heptyloxy group, and an n-octyloxy group.

Examples of the cycloalkyl group (having 5 to 10 carbon atoms) include a cyclopentyl group, a cyclohexyl group, a 1-adamantyl group, and a 2-adamantyl group.

Examples of the cycloalkyloxy group (having 5 to 10 carbon atoms) include a cyclopentyloxy group, a cyclohexyloxy group, a cycloheptyloxy group, a cyclooctyloxy group, a 1-adamantyloxy group, and a 2-adamantyloxy group.

Examples of the alkenyl group (having 2 to 6 carbon atoms) include a vinyl group, an allyl group, an isopropenyl group, and a 2-butenyl group.

Examples of the aryloxy group include a phenyloxy group and a tolyloxy group.

In the general formulas (1) and (2) above, a represents an integer of 0 to 3, and b represents an integer of 0 to 4.

In the high molecular weight compound of the present invention, when one or both of a and b are not 0, R₁ is preferably a deuterium atom. More preferably, a and b are each 0 in view of synthesis.

In the general formula (1) above, R₂ each independently represents an alkyl group or alkyloxy group having 1 to 8 carbon atoms, or a cycloalkyl group or cycloalkyloxy group having 5 to 10 carbon atoms.

For R₂, examples of the alkyl group, the alkyloxy group, the cycloalkyl group, and the cycloalkyloxy group mentioned above include the same groups as described for R₁.

In the high molecular weight compound according to the present invention, R₂ is preferably an alkyl group having 1 to 8 carbon atoms, and more preferably an n-hexyl group or an n-octyl group, in view of enhancing the solubility.

In the general formula (2) above, X represents a hydrogen atom, an amino group, a monovalent aryl group, or a monovalent heteroaryl group.

For X, examples of the monovalent aryl group and the monovalent heteroaryl group include the following groups.

Examples of the aryl group include a phenyl group, a naphthyl group, an anthracenyl group, a phenanthrenyl group, a fluorenyl group, an indenyl group, a pyrenyl group, a perylenyl group, and a fluoranthenyl group.

Examples of the heteroaryl group include a pyridyl group, a pyrimidinyl group, a triazinyl group, a furyl group, a pyrrolyl group, a thienyl group, a quinolyl group, an isoquinolyl group, a benzofuranyl group, a benzothienyl group, an indolyl group, a carbazolyl group, an indenocarbazolyl group, a benzooxazolyl group, a benzothiazolyl group, a quinoxalinyl group, a benzimidazolyl group, a pyrazolyl group, a dibenzofuranyl group, a dibenzothienyl group, a naphthyridinyl group, a phenanthrolinyl group, an acridinyl group, and a carbolinyl group.

The amino group, the aryl group, and the heteroaryl group mentioned above may have a substituent group. Examples of the substituent group include a deuterium atom, a cyano group, a nitro group and also the following groups.

Examples of the substituent group include: halogen atoms such as a fluorine atom, a chlorine atom, a bromine atom, and an iodine atom; alkyl groups, in particular those having 1 to 8 carbon atoms, such as a methyl group, an ethyl group, an n-propyl group, an isopropyl group, an n-butyl group, an isobutyl group, a tert-butyl group, an n-pentyl group, an isopentyl group, a neopentyl group, an n-hexyl group, an isohexyl group, a neohexyl group, an n-heptyl group, an isoheptyl group, a neoheptyl group, an n-octyl group, an isooctyl group, and a neooctyl group; alkyloxy groups, in particular those having 1 to 8 carbon atoms, such as a methyloxy group, an ethyloxy group, and a propyloxy group; alkenyl groups such as a vinyl group and an allyl group; aryloxy groups such as a phenyloxy group and a tolyloxy group; aryl groups such as a phenyl group, a biphenylyl group, a terphenylyl group, a naphthyl group, an anthracenyl group, a phenanthrenyl group, a fluorenyl group, an indenyl group, a pyrenyl group, a perylenyl group, a fluoranthenyl group, and a triphenylenyl group; heteroaryl groups such as a pyridyl group, a pyrimidinyl group, a triazinyl group, a thienyl group, a furyl group, a pyrrolyl group, a quinolyl group, an isoquinolyl group, a benzofuranyl group, a benzothienyl group, an indolyl group, a carbazolyl group, an indenocarbazolyl group, a benzooxazolyl group, a benzothiazolyl group, a quinoxalinyl group, a benzimidazolyl group, a pyrazolyl group, a dibenzofuranyl group, a dibenzothienyl group, and a carbolinyl group; aryl vinyl groups such as a styryl group and a naphthyl vinyl group; and acyl groups such as an acetyl group and a benzoyl group.

The substituent groups listed above may further have any of the substituent groups listed above. Preferably, these substituent groups are each independently present; however, these substituent groups may be bonded to each other to form a ring via a single bond, a methylene group optionally having a substituent group, an oxygen atom, or a sulfur atom.

For example, the aryl group and the heteroaryl group mentioned above each may have a phenyl group as a substituent group, and this phenyl group may further have a phenyl group as a substituent group. In other words, in the case of an aryl group, the aryl group may be a biphenylyl group, a terphenylyl group, or a triphenylenyl group.

In the general formula (1) above, L represents a divalent phenyl group, and n represents an integer of 0 to 3. In the present invention, n is preferably 0 in view of synthesis.

L may have a substituent group. Examples of the substituent group include the same groups as described for the substituent groups for X, and these substituent groups may further have a substituent group.

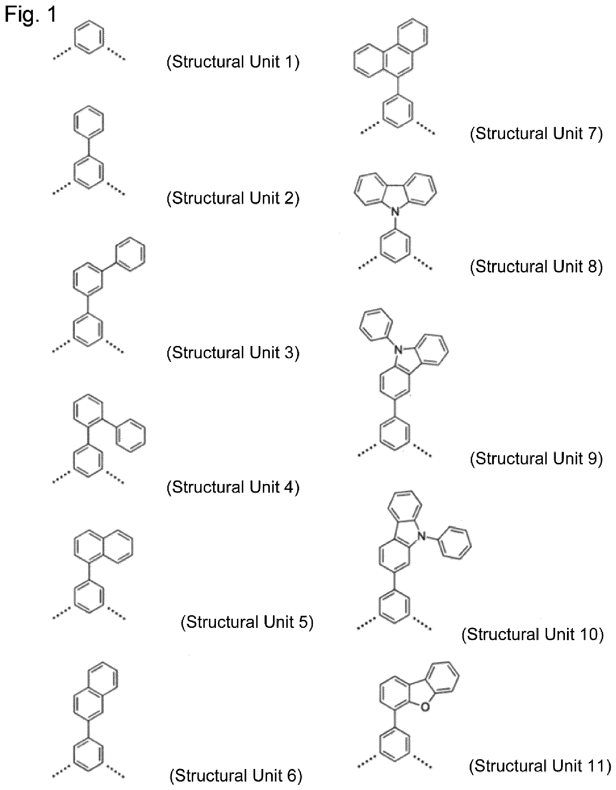

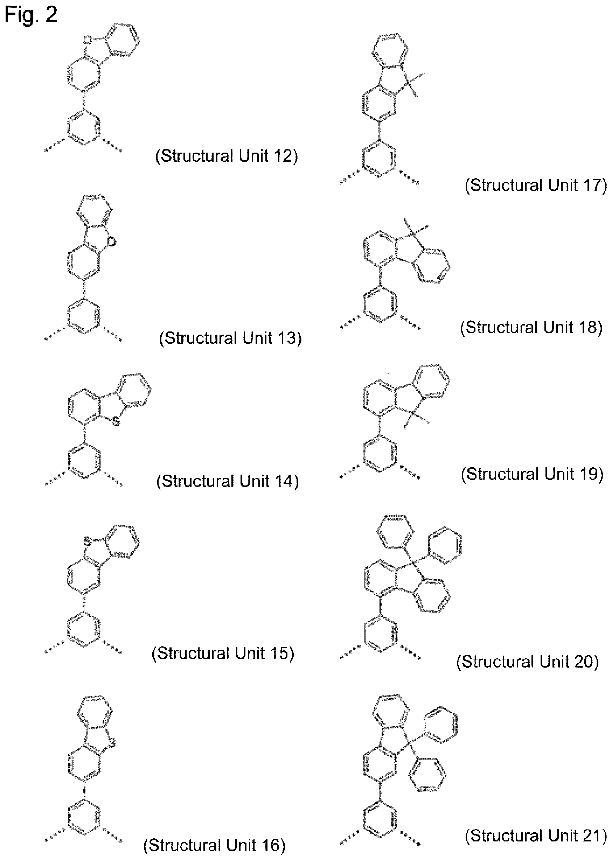

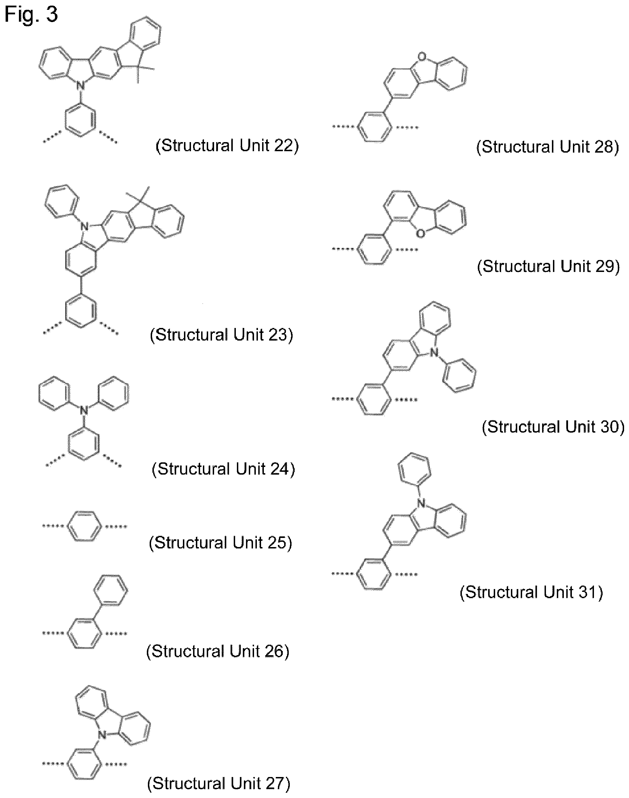

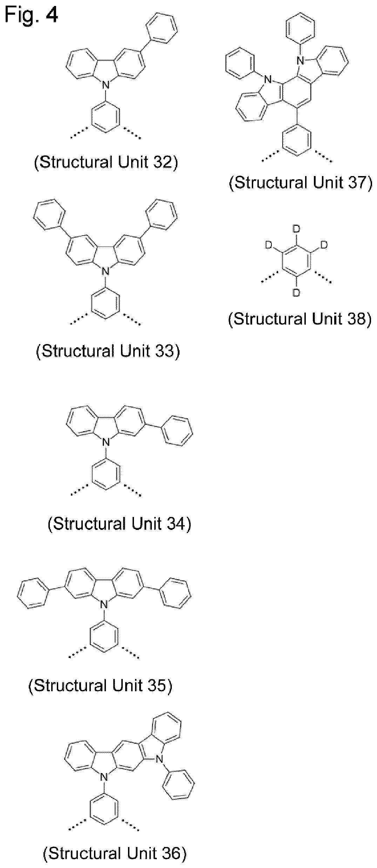

Specific examples of the bonding structural unit represented by the general formula (2) according to the present invention are shown as structural units 1 to 38 in Figs. 1 to 4. In the chemical formulas shown in Figs. 1 to 4, each broken line indicates a bond to an adjacent structural unit, and each solid line that extends from a ring and has a free end indicates substitution with a methyl group. The structural units shown are specific preferable examples of the bonding structural unit; however, the bonding structural unit that may be used in the present invention is not limited thereto.

### <High Molecular Weight Compound>

As already described above, the high molecular weight compound according to the present invention, which includes the repeating unit represented by the general formula (3) constituted by the triarylamine structural unit represented by the general formula (1) above and the bonding structural unit represented by the general formula (2), is excellent in hole-injecting performance, hole mobility, electron-blocking capability, stability in the form of a thin film, heat resistance, and other characteristics. In view of enhancing these characteristics and ensuring film formability, the high molecular weight compound has, for example, a weight average molecular weight preferably in a range of 10,000 or more and less than 1,000,000, more preferably in a range of 10,000 or more and less than 500,000, and even more preferably in a range of 10,000 or more and less than 200,000, in terms of polystyrene, as measured using GPC.

The high molecular weight compound of the present invention preferably contains 50 mol% of the structural unit represented by the general formula (1) (hereinafter, also referred to as the structural unit I) and 50 mol% of the bonding structural unit represented by the general formula (2) (hereinafter, also referred to as the structural unit II). A binary copolymer containing the structural units I and II so as to satisfy the above-described condition is preferable in view of forming an organic layer of an organic EL device.

The high molecular weight compound according to the present invention described above can be synthesized by forming C-C bonds or C-N bonds through a Suzuki polymerization reaction or a HARTWIG-BUCHWALD polymerization reaction so as to link the structural units. Specifically, the high molecular weight compound according to the present invention can be synthesized by providing unit compounds that respectively have the above-described structural units, and subjecting the unit compounds to borate esterification or halogenation as appropriate and then to a polycondensation reaction with an appropriate catalyst.

For example, a triarylamine derivative represented by the following general formula (1a) can be used as the compound for introducing the structural unit represented by the general formula (1). 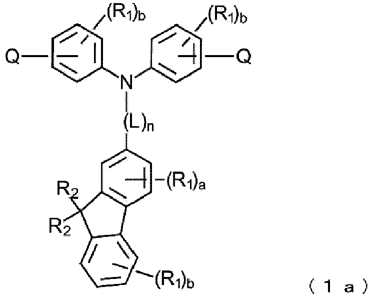 where Q is a hydrogen atom, a halogen atom, or a borate ester group, and all of Ri, R₂, and L are as defined in the general formula (1).

Specifically, the compound represented the general formula (1a) where Q is a hydrogen atom is the unit compound for introducing the structural unit represented by the general formula (1), and the compound represented the general formula (1a) where Q is a halogen atom or a borate ester group is a halide or a borate ester used to synthesize a polymer. The halogen atom is preferably Br.

For example, a copolymer containing 50 mol% of the structural unit I represented by the general formula (1) and 50 mol% of the structural unit II represented by the general formula (2) is represented by a general formula (4) below.

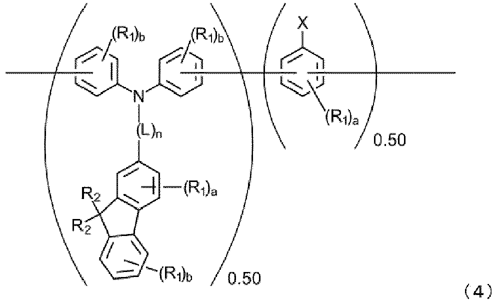

This high molecular weight compound can be synthesized through a polycondensation reaction of a borate ester and a halide. It is necessary that an intermediate for introducing the structural unit I is a borate ester whereas an intermediate for introducing the structural unit II is a halide, or that an intermediate for introducing the structural unit I is a halide whereas an intermediate for introducing the structural unit II is a borate ester. Namely, it is necessary that the molar ratio of the halide and that of the borate ester should be equal.

The high molecular weight compound according to the present invention described above may be dissolved in an aromatic organic solvent such as benzene, toluene, xylene, or anisole to prepare a coating solution, and the coating solution may be applied to a substrate to form a coating, followed by heating and drying. In this way, a thin film excellent in hole-injecting performance, hole-transporting performance, electron-blocking performance and other characteristics can be formed. The thin film also has good heat resistance and good adhesion to other layers.

The high molecular weight compound described above can be used as a constituent material of a hole-injecting layer and/or a hole-transporting layer of an organic EL device. The hole-injecting layer or the hole-transporting layer formed by using the high molecular weight compound described above has higher hole-injecting performance, greater hole mobility, and higher electron-blocking performance than the hole-injecting layer or the hole-transporting layer formed by using a conventional material. In addition, the hole-injecting layer or the hole-transporting layer formed by using the high molecular weight compound described above can confine excitons generated in a light-emitting layer, improve the probability of recombination of holes and electrons, and provide high luminous efficacy. Furthermore, the hole-injecting layer or the hole-transporting layer formed by using the high molecular weight compound described above can advantageously achieve a decrease in the driving voltage to improve the durability of the organic EL device.

Also, the high molecular weight compound according to the present invention having the electrical characteristics described above has a wider bandgap than that of conventional materials, and is effective to confine excitons. Accordingly, the high molecular weight compound according to the present invention can also be preferably used for an electron-blocking layer or a light-emitting layer.

### <Organic EL Device>

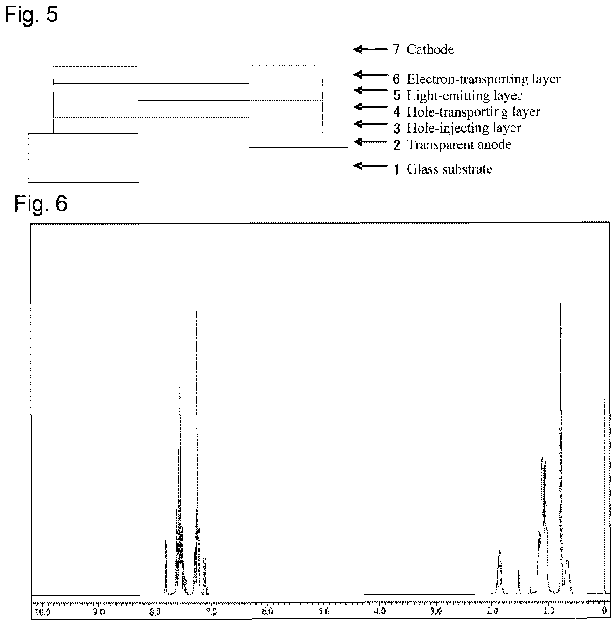

An organic EL device that includes an organic layer formed by using the high molecular weight compound according to the present invention described above has, for example, a structure shown in Fig. 5. Specifically, a transparent anode 2, a hole-injecting layer 3, a hole-transporting layer 4, a light-emitting layer 5, an electron-transporting layer 6, and a cathode 7 are formed on a glass substrate 1 (which may be a transparent substrate such as a transparent resin substrate).

It will be appreciated that the layer structure of the organic EL device to which the high molecular weight compound according to the present invention is applied is not limited to that described above. A hole-blocking layer may be provided between the light-emitting layer 5 and the electron-transporting layer 6. Also, an electron-blocking layer may be provided between the hole-transporting layer 4 and the light-emitting layer 5. Also, an electron-injecting layer may be provided between the cathode 7 and the electron-transporting layer 6. Also, at least one layer may be omitted. For example, the organic EL device may have a simple layer structure in which an anode 2, a hole-transporting layer 4, a light-emitting layer 5, an electron-transporting layer 6, and a cathode 7 are provided on a substrate 1. A double-layer structure may be used in which layers having the same function are overlaid.

Taking advantage of characteristics such as hole-injecting performance and hole-transporting performance, the high molecular weight compound according to the present invention is preferably used as a material for an organic layer (e.g., a hole-injecting layer 3, a hole-transporting layer 4, a light-emitting layer 5, or an electron-blocking layer) provided between the anode 2 and the cathode 7.

In the organic EL device described above, the transparent anode 2 may be made of an electrode material that is known per se, and may be formed by depositing an electrode material having a large work function, such as ITO or gold, on a substrate 1 (a transparent substrate such as a glass substrate).

The hole-injecting layer 3 on the transparent anode 2 can be formed by using a coating solution prepared by dissolving the high molecular weight compound according to the present invention in, for example, an aromatic organic solvent such as toluene, xylene, or anisole. Specifically, the hole-injecting layer 3 can be formed by applying the coating solution to the transparent anode 2 by spin coating, inkjet printing, or the like so as to form a coating.

In the organic EL device including the organic layer formed by using the high molecular weight compound according to the present invention, the hole-injecting layer 3 can also be formed by using a conventionally known material, without using the high molecular weight compound according to the present invention. Examples of the conventionally known material include:
a porphyrin compound typified by copper phthalocyanine;
a star burst triphenylamine derivative;
an arylamine having a structure in which molecules are linked via a single bond or a divalent group having no hetero atom (e.g., a triphenylamine trimer or tetramer);
an acceptor-type heterocyclic ring compound such as hexacyanoazatriphenylene; and
a coating polymer material such as poly(3,4-ethylenedioxythiophene) (PEDOT), or poly(styrenesulfonate) (PSS).

A layer (thin film) can be formed by a deposition method or a coating method, such as spin-coating or inkjet printing, with any of the materials listed above. The same applies to other layers, and a film is formed by a deposition method or a coating method according to the type of the material for forming the film.

As with the hole-injecting layer 3, the hole-transporting layer 4 on the hole-injecting layer 3 can also be formed by a coating method, such as spin-coating or inkjet printing, with the high molecular weight compound according to the present invention.

In the organic EL device including the organic layer formed by using the high molecular weight compound according to the present invention, the hole-transporting layer 4 can also be formed by using a conventionally known hole-transporting material. Typical examples of the hole-transporting material are as follows.

Examples of the hole-transporting material include:
benzidine derivatives such as
   N,N'-diphenyl-N,N'-di(m-tolyl)benzidine (hereinafter referred to simply as TPD),
   N,N'-diphenyl-N,N'-di(α-naphthyl)benzidine (hereinafter referred to simply as NPD), and
   N,N,N',N'-tetrabiphenylyl benzidine; and
amine derivatives such as
   1,1-bis[4-(di-4-tolylamino)phenyl]cyclohexane (hereinafter referred to simply as TAPC),
   various types of triphenylamine trimers and tetramers, and
   coating polymer materials that can also be used to form a hole-injecting layer.

The compounds for forming a hole-transporting layer, including the high molecular weight compound according to the present invention, may be used singly or in combination of two or more to form a hole-transporting layer. As the hole-transporting layer, a multi-layer film may also be used that includes a plurality of layers each formed by using one or more of the compounds listed above.

In the organic EL device including the organic layer formed by using the high molecular weight compound according to the present invention, the hole-injecting layer 3 and the hole-transporting layer 4 may be combined into one layer. Such a hole-injecting/transporting layer can be formed by coating with a polymer material such as PEDOT.

For the hole-transporting layer 4, a material obtained by p-doping a material usually used to form a hole-transporting layer with trisbromophenylaminehexachloroantimony, a radialene derivative (see WO 2014/009310, for example), or the like can also be used (the same also applies to the hole-injecting layer 3). The hole-transporting layer 4 (or the hole-injecting layer 3) can also be formed by using a high molecular compound that has a TPD skeleton, for example.

An electron-blocking layer (which can be provided between the hole-transporting layer 4 and the light-emitting layer 5) can also be formed by a coating method, such as spin-coating or inkjet printing, with the high molecular weight compound according to the present invention.

In the organic EL device including the organic layer formed by using the high molecular weight compound according to the present invention, an electron-blocking layer can also be formed by using a known electron blocking compound having an electron blocking function, such as a carbazole derivative or a compound having a triphenylsilyl group and a triarylamine structure. Specific examples of the carbazole derivative and the compound having a triarylamine structure are as follows.

Examples of the carbazole derivative include:
4,4',4"-tri(N-carbazolyl)triphenylamine (hereinafter referred to simply as TCTA);
9,9-bis[4-(carbazole-9-yl)phenyl]fluorene;
1,3-bis(carbazole-9-yl)benzene (hereinafter referred to simply as mCP); and
2,2-bis[4-(carbazole-9-yl)phenyl]adamantane (hereinafter referred to simply as Ad-Cz).

Examples of the compound having a triarylamine structure include 9-[4-(carbazole-9-yl)phenyl]-9-[4-(triphenylsilyl)phenyl]-9H-fluorene.

The compounds for forming an electron-blocking layer, including the high molecular weight compound according to the present invention, may be used singly or in combination of two or more to form an electron-blocking layer. As the electron-blocking layer, a multi-layer film may be used that includes a plurality of layers each formed by using one or more of the compounds listed above.

In the organic EL device including the organic layer formed by using the high molecular weight compound according to the present invention, the light-emitting layer 5 can be formed by using a light emitting material such as a metal complex of a quinolinol derivative such as Alq₃. Other examples of the light emitting material include various types of metal complexes of zinc, beryllium, aluminum and the like, an anthracene derivative, a bisstyrylbenzene derivative, a pyrene derivative, an oxazole derivative, and a polyphenylene vinylene derivative.

The light-emitting layer 5 can also be formed by using a host material and a dopant material. In this case, as the host material, the light emitting materials listed above can be used, and a thiazole derivative, a benzimidazole derivative, a polydialkylfluorene derivative, and the like can also be used. The high molecular weight compound according to the present invention described above can also be used. As the dopant material, quinacridone, coumalin, rubrene, perylene, and derivatives thereof, a benzopyran derivative, a rhodamine derivative, an aminostyryl derivative, and the like can be used.

The light-emitting layer 5 may have a single-layer or multi-layer structure formed by using one or more of the light emitting materials listed above.

The light-emitting layer 5 can also be formed by using a phosphorescent light emitting material as the light emitting material. As the phosphorescent light emitting material, a phosphorescent emitter can be used, including a metal complex of iridium, platinum, or the like. Examples thereof include a green phosphorescent emitter such as Ir(ppy)₃, a blue phosphorescent emitter such as FIrpic or FIr6, and a red phosphorescent emitter such as Btp₂Ir (acac). The phosphorescent light emitting material is used by being doped into a host material that has hole-injecting/transporting capability or a host material that has electron-transporting capability.

In order to avoid concentration quenching, it is preferable to dope the phosphorescent light emitting material in an amount within a range of 1 to 30 wt% based on the entire light-emitting layer, into the host material by co-deposition.

As the light emitting material, a material that emits delayed fluorescence can also be used, including a CDCB derivative, specifically, PIC-TRZ, CC2TA, PXZ-TRZ, 4CzIPN, or the like (see Appl. Phys. Let., 98, 083302 (2011)).

In a case where the light-emitting layer 5 is formed such that the high molecular weight compound according to the present invention carries a so-called dopant, such as a fluorescent emitter, a phosphorescent emitter, or a material that emits delayed fluorescence, an organic EL device that has a low driving voltage and improved luminous efficacy can be provided.

In the organic EL device including the organic layer formed by using the high molecular weight compound according to the present invention, the high molecular weight compound according to the present invention can be used as the host material having hole-injecting/transporting capability. A carbazole derivative can also be used, including 4,4'-di(N-carbazolyl)biphenyl (hereinafter referred to simply as CBP), TCTA, and mCP.

In the organic EL device including the organic layer formed by using the high molecular weight compound according to the present invention, p-bis(triphenylsilyl)benzene (hereinafter referred to simply as UGH2), 2,2',2"-(1,3,5-phenylene)-tris(1-phenyl-1H-benzimidazole) (hereinafter referred to simply as TPBI), or the like can be used as the host material having electron-transporting capability.

In the organic EL device including the organic layer formed by using the high molecular weight compound according to the present invention, the hole-blocking layer (not shown in the diagram) between the light-emitting layer 5 and the electron-transporting layer 6 can be formed by using a compound having hole-blocking capability that is known per se. Examples of the known compound having hole-blocking capability are as follows.

Examples of the compound having a hole-blocking capability include:
a phenanthroline derivative such as bathocuproine (hereinafter referred to simply as BCP);
a metal complex of a quinolinol derivative such as aluminum (III)bis(2-methyl-8-quinolinate)-4-phenylphenolate (hereinafter referred to simply as BAlq);
various types of rare-earth complexes;
a triazole derivative;
a triazine derivative; and
an oxadiazole derivative.

These materials can also be used to form an electron-transporting layer 6, which will be described below, and can also be used for a layer serving both the hole-blocking layer and the electron-transporting layer.

The hole-blocking layer may also have a single-layer or multi-layer structure in which each layer is formed by using one or more of the compounds having a hole-blocking capability listed above.

In the organic EL device including the organic layer formed by using the high molecular weight compound according to the present invention, the electron-transporting layer 6 is formed by using a compound having electron-transporting capability that is known per se. Examples of the known compound having electron-transporting capability include metal complexes of quinolinol derivatives such as Alq₃ and BAlq, various types of metal complexes, a pyridine derivative, a pyrimidine derivative, a triazole derivative, a triazine derivative, an oxadiazole derivative, a thiadiazole derivative, a carbodiimide derivative, a quinoxaline derivative, a phenanthroline derivative, a silole derivative, and a benzimidazole derivative.

The electron-transporting layer 6 may also have a single-layer or multi-layer structure in which each layer is formed by using one or more of the compounds having electron-transporting capability listed above.

In the organic EL device including the organic layer formed by using the high molecular weight compound according to the present invention, the optional electron-injecting layer (not shown in the diagram) can also be formed by using a material that is known per se. Examples of the known material include: alkali metal salts such as lithium fluoride and cesium fluoride; alkaline earth metal salts such as magnesium fluoride; metal oxides such as aluminum oxide; and organic metal complexes such as lithium quinoline.

In the organic EL device including the organic layer formed by using the high molecular weight compound according to the present invention, the cathode 7 is formed by using an electrode material having a low work function, such as aluminum, or an alloy having an even lower work function, such as a magnesium-silver alloy, a magnesium-indium alloy, or an aluminum-magnesium alloy.

As described above, at least one of the hole-injecting layer, the hole-transporting layer, the light-emitting layer, and the electron-blocking layer in an organic EL device may be formed by using the high molecular weight compound according to the present invention, and the organic EL device thus obtained has high luminous efficacy, high power efficiency, a low actual driving voltage, a low voltage at the start of light emission, and outstanding durability. In particular, the organic EL device has not only high luminous efficacy but also a low driving voltage, improved current tolerance, and improved maximum luminance.

### Examples

Hereinafter, the present invention will be described by way of examples.

In the description given below, the structural unit represented by the general formula (1) included in the high molecular weight compound according to the present invention will be referred to as "structural unit I", and the bonding structural unit represented by the general formula (2) included in the same will be referred to as "structural unit II".

Purification of a synthesized compound was performed by column chromatography or crystallization with a solvent, and identification of the compound was performed by NMR analysis.

### <Synthesis of Intermediate 1>

In order to produce high molecular weight compounds according to the present invention, an intermediate 1 for introducing the structural unit I was synthesized.

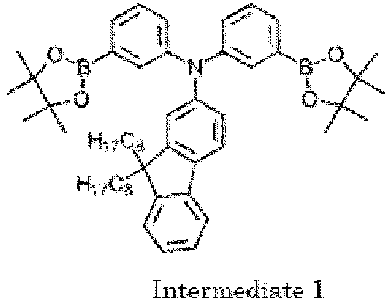

The following components were placed in a reaction vessel purged with nitrogen, and nitrogen gas was passed through the reaction vessel for 30 minutes:
43.4 g of N,N-bis(3-bromophenyl)-9,9-dioctyl-9H-fluorene-2-amine;
32.3 g of bis(pinacolato)diboron;
17.9 g of potassium acetate; and
220 ml of 1,4-dioxane.

Then, 1.0 g of [1,1'-bis(diphenylphosphino)ferrocene]palladium(II)dichloride dichloromethane adduct was added, and the mixture was heated and stirred at 100°C for 13 hours.

After the mixture was cooled down to room temperature, water and toluene were added, and an organic layer was collected by separation treatment and washed with saturated saline three times. The organic layer was dried over sodium sulfate anhydrous, and then concentrated under reduced pressure to obtain a crude product. The crude product was purified by column chromatography (ethyl acetate / n-hexane = 1/20), to obtain 22.9 g of intermediate 1 in the form of a white powder (yield: 45%).

### Example 1

### (Synthesis of High Molecular Weight Compound A)

The following components were placed in a reaction vessel purged with nitrogen, and nitrogen gas was passed through the reaction vessel for 30 minutes:
5.6 g of N,N-bis[4-(4,4,5,5-tetramethyl-1,3,2-dioxaborolane-2-yl)phenyl]-9,9-dioctyl-9H-fluorene-2-amine;
1.6 g of 1,3-dibromobenzene;
7.7 g of tripotassium phosphate;
9 ml of toluene;
5 ml of water; and
27 ml of 1,4-dioxane.

Then, 1.6 mg of palladium (II) acetate and 12.9 mg of tri-o-tolylphosphine were added, and the mixture was heated and stirred at 85°C for 11 hours. Subsequently, 19 mg of phenylboronic acid was added and the mixture was stirred for 1 hour. Then, 271 mg of bromobenzene was added and the mixture was stirred for 1 hour. Then, 50 ml of toluene and 50 ml of a 5 wt% sodium N,N-diethyldithiocarbamate aqueous solution were added, and the mixture was heated and stirred under reflux for 2 hours. After the mixture was cooled down to room temperature, an organic layer was collected by separation treatment and washed with saturated saline three times. The organic layer was dried over magnesium sulfate anhydrous, and then concentrated under reduced pressure to obtain a crude polymer. The crude polymer was dissolved in toluene. A silica gel was added to perform adsorptive purification, and then the silica gel was removed by filtration. The obtained filtrate was concentrated under reduced pressure, and 100 ml of toluene was added to the dried solid to dissolve the dried solid therein. The resultant was added dropwise to 300 ml of n-hexane, and the precipitate formed was collected by filtration. This operation was repeated three times, and the resultant was dried to obtain 3.2 g of high molecular weight compound A (yield: 70%).

The average molecular weight and the dispersity of the high molecular weight compound A measured using GPC were as follows.
Number average molecular weight Mn (in terms of polystyrene): 56,000
Weight average molecular weight Mw (in terms of polystyrene): 89,000
Dispersity (Mw/Mn): 1.6

Furthermore, the high molecular weight compound A was analyzed using NMR. Fig. 6 shows the results of ¹H-NMR. The structure of the high molecular weight compound A was as follows.

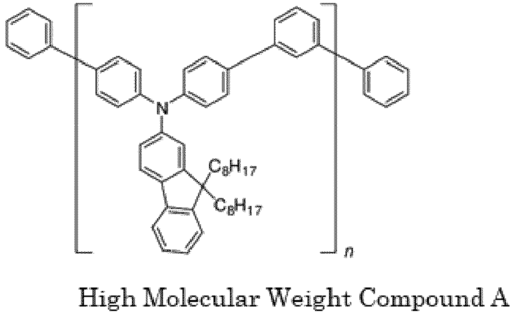

As is seen from the structural formula above, the high molecular weight compound A contained 50 mol% of the structural unit I represented by the general formula (1) and 50 mol% of the structural unit II represented by the general formula (2).

### Example 2

### (Synthesis of High Molecular Weight Compound B)

The following components were placed in a reaction vessel purged with nitrogen, and nitrogen gas was passed through the reaction vessel for 30 minutes:
6.6 g of intermediate 1;
1.9 g of 1,3-dibromobenzene;
9.1 g of tripotassium phosphate;
12 ml of toluene;
7 ml of water; and
36 ml of 1,4-dioxane.

Then, 1.9 mg of palladium (II) acetate and 15.1 mg of tri-o-tolylphosphine were added, and the mixture was heated and stirred at 85°C for 11.5 hours. Subsequently, 23 mg of phenylboronic acid was added and the mixture was stirred for 1 hour. Then, 319 mg of bromobenzene was added and the mixture was stirred for 1 hour. Then, 50 ml of toluene and 50 ml of a 5 wt% sodium N,N-diethyldithiocarbamate aqueous solution were added, and the mixture was heated and stirred under reflux for 2 hours. After the mixture was cooled down to room temperature, an organic layer was collected by separation treatment and washed with saturated saline three times. The organic layer was dried over sodium sulfate anhydrous, and then concentrated under reduced pressure to obtain a crude polymer. The crude polymer was dissolved in toluene. A silica gel was added to perform adsorptive purification, and then the silica gel was removed by filtration. The obtained filtrate was concentrated under reduced pressure, and 30 ml of toluene was added to the dried solid to dissolve the dried solid therein. The resultant was added dropwise to 400 ml of n-hexane, and the precipitate formed was collected by filtration. This operation was repeated one more time, and the resultant was dried to obtain 1.6 g of high molecular weight compound B (yield: 30%).

The average molecular weight and the dispersity of the high molecular compound B measured using GPC were as follows.
Number average molecular weight Mn (in terms of polystyrene): 38,000
Weight average molecular weight Mw (in terms of polystyrene): 50,000
Dispersity (Mw/Mn): 1.3

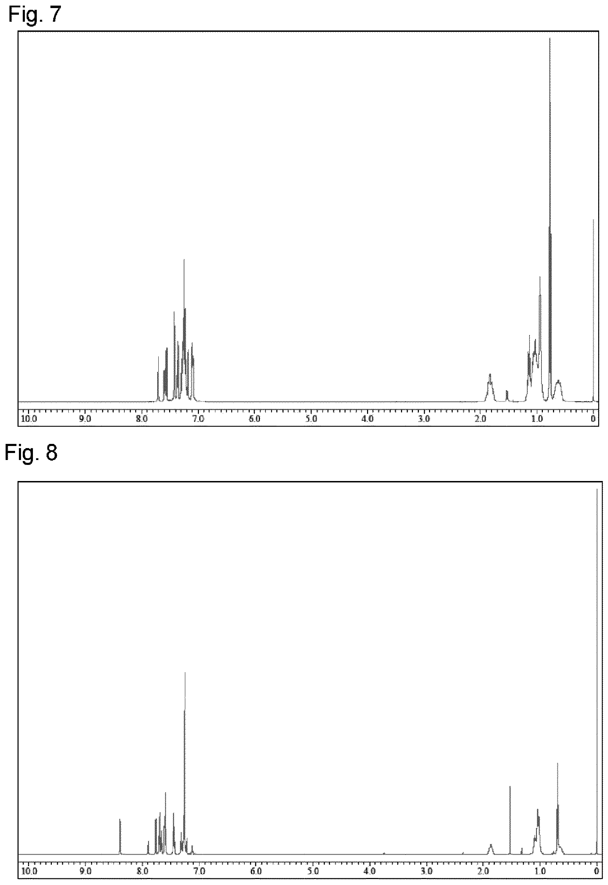

Furthermore, the high molecular weight compound B was analyzed using NMR. Fig. 7 shows the results of ¹H-NMR. The structure of the high molecular weight compound B was as follows.

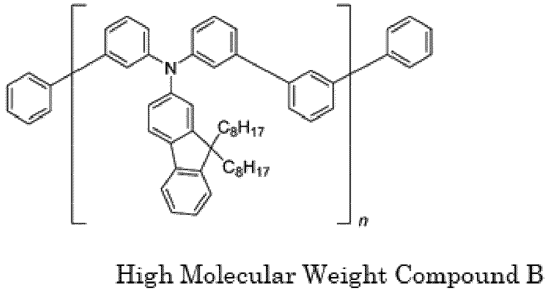

As is seen from the structural formula above, the high molecular weight compound B contained 50 mol% of the structural unit I represented by the general formula (1) and 50 mol% of the structural unit II represented by the general formula (2).

### Example 3

### (Synthesis of High Molecular Weight Compound C)

The following components were placed in a reaction vessel purged with nitrogen, and nitrogen gas was passed through the reaction vessel for 30 minutes:
5 g of N,N-bis[4-(4,4,5,5-tetramethyl-1,3,2-dioxaborolane-2-yl)phenyl]-9,9-dioctyl-9H-fluorene-2-amine;
1.6 g of 9-(3,5-dibromophenyl)-3,6-diphenyl-9H-carbazole;
3.4 g of tripotassium phosphate;
7 ml of toluene;
4 ml of water; and
21 ml of 1,4-dioxane.

Then, 1.4 mg of palladium (II) acetate and 11.5 mg of tri-o-tolylphosphine were added, and the mixture was heated and stirred at 85°C for 12 hours. Subsequently, 17 mg of phenylboronic acid was added and the mixture was stirred for 1 hour. Then, 242 mg of bromobenzene was added and the mixture was stirred for 1 hour. Then, 50 ml of toluene and 50 ml of a 5 wt% sodium N,N-diethyldithiocarbamate aqueous solution were added, and the mixture was heated and stirred under reflux for 2 hours. After the mixture was cooled down to room temperature, an organic layer was collected by separation treatment and washed with saturated saline three times. The organic layer was dried over sodium sulfate anhydrous, and then concentrated under reduced pressure to obtain a crude polymer. The crude polymer was dissolved in toluene. A silica gel was added to perform adsorptive purification, and then the silica gel was removed by filtration. The obtained filtrate was concentrated under reduced pressure, and 100 ml of toluene was added to the dried solid to dissolve the dried solid therein. The resultant was added dropwise to 300 ml of n-hexane, and the precipitate formed was collected by filtration. This operation was repeated three times, and the resultant was dried to obtain 1.8 g of high molecular weight compound C (yield: 30%).

The average molecular weight and the dispersity of the high molecular weight compound C measured using GPC were as follows.
Number average molecular weight Mn (in terms of polystyrene): 45,000
Weight average molecular weight Mw (in terms of polystyrene): 73,000
Dispersity (Mw/Mn): 1.6

Furthermore, the high molecular weight compound C was analyzed using NMR. Fig. 8 shows the results of ¹H-NMR. The structure of the high molecular weight compound C was as follows.

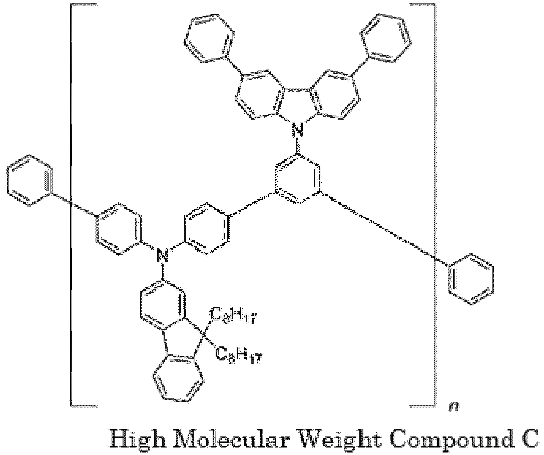

As is seen from the structural formula above, the high molecular weight compound C contained 50 mol% of the structural unit I represented by the general formula (1) and 50 mol% of the structural unit II represented by the general formula (2).

### Example 4

### (Measurement of Work Function)

A coating film having a thickness of 80 nm was formed on an ITO substrate by using one of the high molecular weight compounds A, B, and C synthesized in Examples 1, 2, and 3, and the work function were measured using an ionization potential measurement system (Model PYS-202 available from Sumitomo Heavy Industries, Ltd.). The results were as follows.

**Table 1**

| | | Work function (eV) |
|---|---|---|
| Ex. 1 | High molecular weight compound A | 5.66 |
| Ex. 2 | High molecular weight compound B | 5.74 |
| Ex. 3 | High molecular weight compound C | 5.82 |

The high molecular weight compounds A, B, and C according to the present invention had a better energy level than common hole-transporting materials such as NPD and TPD, which have a work function of 5.4 eV. This means that the high molecular weight compounds A, B, and C have good hole-transporting capability.

### Example 5

### (Production and Evaluation of Organic EL Device)

An organic EL device having a layer structure shown in Fig. 5 was produced in the following manner.

A glass substrate 1 on which an ITO film having a thickness of 50 nm was formed was washed with an organic solvent, and then UV/ozone treatment was performed to clean the surface of the ITO film. A PEDOT/PSS (available from HERAEUS) was applied using a spin coating method so as to cover the transparent anode 2 (ITO) formed on the glass substrate 1, thereby forming a 50-nm thick film. The film was dried on a hot plate at 200°C for 10 minutes, thereby forming a hole-injecting layer 3.

A coating solution was prepared by dissolving the high molecular weight compound A obtained in Example 1 in toluene to a concentration of 0.6 wt%. The substrate on which the hole-injecting layer 3 was formed in the manner described above was placed in a glove box purged with dry nitrogen. A coating layer having a thickness of 25 nm was formed on the hole-injecting layer 3 by spin coating with the coating solution described above, and dried on a hot plate at 220°C for 30 minutes, thereby forming a hole-transporting layer 4.

The substrate on which the hole-transporting layer 4 was formed in the manner described above was set in a vacuum deposition machine, and the pressure was reduced to 0.001 Pa or less. A light-emitting layer 5 having a thickness of 34 nm was formed on the hole-transporting layer 4 by binary deposition of a blue light emitting material (EMD-1) and a host material (EMH-1) represented by the structure formulas below. In the binary deposition, the ratio of deposition rate was set to EMD-1 : EMH-1 = 4 : 96.

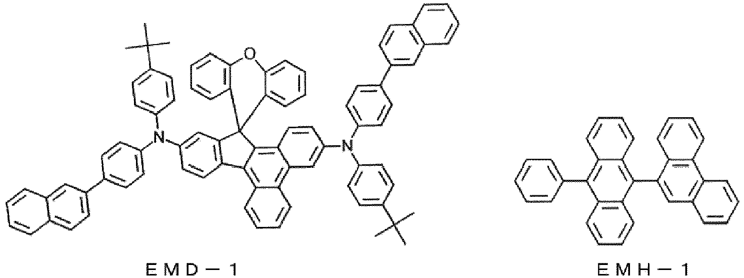

Compounds ETM-1 and ETM-2 represented by the structural formulas below were provided as the electron transport materials.

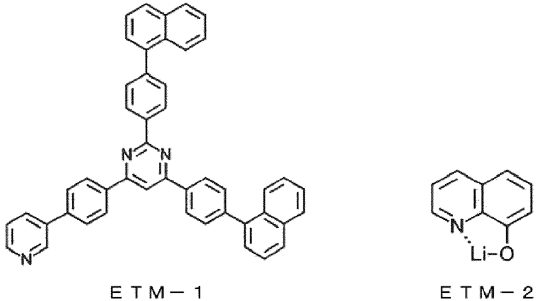

An electron-transporting layer 6 having a thickness of 20 nm was formed on the formed light-emitting layer 5 by binary deposition of the electron transport materials ETM-1 and ETM-2. In the binary deposition, the ratio of deposition rate was set to ETM-1 : ETM-2 = 50 : 50.

Finally, aluminum was deposited so as to form a film having a thickness of 100 nm, thereby forming a cathode 7.

The glass substrate on which the transparent anode 2, the hole-injecting layer 3, the hole-transporting layer 4, the light-emitting layer 5, the electron-transporting layer 6, and the cathode 7 were thus formed was placed in a glove box purged with dry nitrogen, and another glass substrate for sealing was bonded thereto with a UV curable resin, thereby obtaining an organic EL device. The produced organic EL device was characterized in an atmosphere at room temperature. Also, light emission characteristics when applying a DC voltage to the organic EL device were determined. The results are shown in Table 2.

### Example 6

An organic EL device was produced in the same manner as in Example 5, except that the hole-transporting layer 4 was formed by using a coating solution prepared by dissolving, instead of the high molecular weight compound A, the compound of Example 2 (the high molecular weight compound B) in toluene to a concentration of 0.6 wt%. The produced organic EL device was characterized in an atmosphere at room temperature. The results of light emission characteristics when applying a DC voltage to the organic EL device are collectively shown in Table 2.

### Example 7

An organic EL device was produced in the same manner as in Example 5, except that the hole-transporting layer 4 was formed by using a coating solution prepared by dissolving, instead of the high molecular weight compound A, the compound of Example 3 (the high molecular weight compound C) in toluene to a concentration of 0.6 wt%. The produced organic EL device was characterized in an atmosphere at room temperature. The results of light emission characteristics when applying a DC voltage to the organic EL device are collectively shown in Table 2.

### Comparative Example 1

An organic EL device was produced in the same manner as in Example 5, except that the hole-transporting layer 4 was formed by using a coating solution prepared by dissolving, instead of the high molecular weight compound A, TFB (hole transport polymer) shown below in toluene to a concentration of 0.6 wt%.

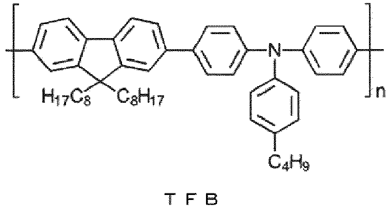

TFB (hole transport polymer) is poly[(9,9-dioctylfluorenyl-2,7-diyl)-co-(4,4'-(N-(4-sec-butylphenyl))diphenylamine] (Hole Transport Polymer ADS259BE available from American Dye Source). Various characteristics of the organic EL device of Comparative Example 1 were evaluated in the same manner as in Example 5. The results are shown in Table 2.

In the evaluation of various characteristics, the device lifespan is defined as follows: the organic EL device was driven by constant current to emit light at an initial luminance (luminance when light emission started) of 700 cd/m², and the time taken for the luminance to decay to 560 cd/m² (corresponding to 80% based on the initial luminance (100%): 80% decay) was determined and used as the element lifespan.

**Table 2**

| | Hole-transporting layer | Voltage [V] (@10 mA/cm²) | Luminance [cd/m²] (@10 mA/cm²) | Luminous efficacy [cd/A] (@10 mA/cm²) | Power efficiency [lm/W] (@10 mA/cm²) | Device lifespan 80% decay (@700 cd/m²) |
|---|---|---|---|---|---|---|
| Ex. 5 | High molecular weight compound A | 4.18 | 865 | 8.65 | 6.51 | 440 hours |
| Ex. 6 | High molecular weight compound B | 4.45 | 764 | 7.62 | 5.39 | 9.9 hours |
| Ex. 7 | High molecular weight compound C | 4.47 | 1033 | 10.34 | 7.28 | 63.9 hours |
| Com. Ex. 1 | TFB | 4.08 | 552 | 5.52 | 4.26 | 5.9 hours |

The following can be seen from Table 2. The organic EL devices of both Examples and Comparative Example exhibited a low actual driving voltage. When a current with an electric current density of 10 mA/cm² was applied, the organic EL device of Comparative Example 1 had a luminous efficacy of 5.52 cd/A, and the organic EL devices of Examples 5, 6, and 7 had light emission efficiencies of 8.65 cd/A, 7.62 cd/A, and 10.34 cd/A, respectively. In short, all of the organic EL devices of Examples exhibited high efficiency. In addition, the organic EL device of Comparative Example 1 had a device lifespan (80% decay) of 5.9 hours; in contrast, the organic EL device of Example 5 had a device lifespan of 440 hours, which was unexpectedly significant improvement in the lifespan, and the organic EL devices of Examples 6 and 7 had also a long device lifespan of 9.9 hours and 63.9 hours, respectively.

### Industrial Applicability

The high molecular weight compound according to the present invention has high hole-transporting capability and excellent electron-blocking capability, and is excellent as a compound for various types of light emitting diodes, such as organic EL devices, which are self-emissive devices, and more preferably coating-type organic EL devices. Coating-type organic EL devices produced by using the compound have high luminous efficacy, high power efficiency, and also improved durability. Accordingly, the coating-type organic EL devices can be used in a wide range of applications such as home electric appliances and lighting equipment.

### List of Reference Numerals

- 1: Glass substrate
- 2: Transparent anode
- 3: Hole-injecting layer
- 4: Hole-transporting layer
- 5: Light-emitting layer
- 6: Electron-transporting layer
- 7: Cathode

## Claims

1. A high molecular weight compound comprising a repeating unit represented by a general formula (3) below, which is constituted by a triarylamine structural unit represented by a general formula (1) below and a bonding structural unit represented by a general formula (2) below, and having a weight average molecular weight of 10,000 or more and less than 1,000,000, in terms of polystyrene: 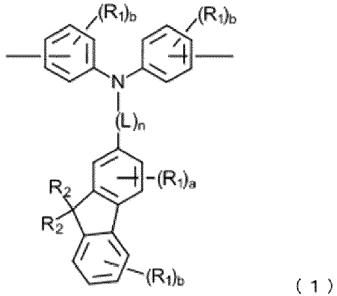 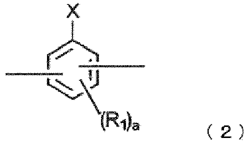 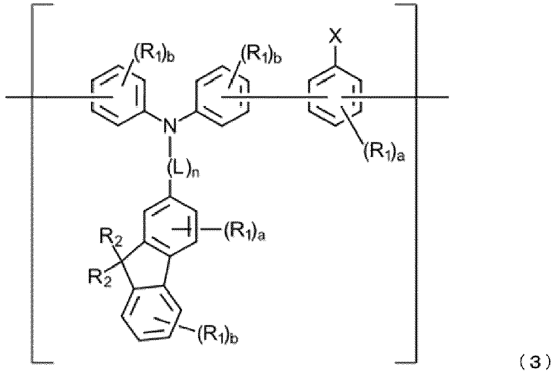
where Ri each independently represents a deuterium atom, a cyano group, a nitro group, a fluorine atom, a chlorine atom, a bromine atom, an iodine atom, an alkyl group or alkyloxy group having 1 to 8 carbon atoms, a cycloalkyl group or cycloalkyloxy group having 5 to 10 carbon atoms, an alkenyl group having 2 to 6 carbon atoms, or an aryloxy group,
R₂ each independently represents an alkyl group or alkyloxy group having 1 to 8 carbon atoms, or a cycloalkyl group or cycloalkyloxy group having 5 to 10 carbon atoms,
X represents a hydrogen atom, an amino group, a monovalent aryl group, or a monovalent heteroaryl group,
L represents a divalent phenyl group,
n represents an integer of 0 to 3,
a represents an integer of 0 to 3, and
b represents an integer of 0 to 4.

2. The high molecular weight compound according to claim 1, wherein a and b are 0.

3. The high molecular weight compound according to claim 1 or 2, wherein R₂ is an alkyl group having 1 to 8 carbon atoms.

4. The high molecular weight compound according to any one of claims 1 to 3, wherein X is a hydrogen atom.

5. The high molecular weight compound according to any one of claims 1 to 3, wherein X is a diphenylamino group, a phenyl group, a naphthyl group, a dibenzofuranyl group, a dibenzothienyl group, a phenanthrenyl group, a fluorenyl group, a carbazolyl group, an indenocarbazolyl group, or an acridinyl group.

6. A light emitting diode comprising a pair of electrodes and one or more organic layers sandwiched therebetween,
wherein at least one of the organic layers contains the high molecular weight compound according to any one of claims 1 to 5, as a constituent material.

7. The light emitting diode according to claim 6, wherein the organic layer is a hole-transporting layer.

8. The light emitting diode according to claim 6, wherein the organic layer is an electron-blocking layer.

9. The light emitting diode according to claim 6, wherein the organic layer is a hole-injecting layer.

10. The light emitting diode according to claim 6, wherein the organic layer is a light-emitting layer.

11. The light emitting diode according to any one of claim 6 to 10, which is an organic electroluminescence device.
